# EUROPEAN PATENT APPLICATION

(11) **EP 1 619 714 A1**
(43) Date of publication of application: **25.01.2006**
(21) Application number: 04017100.1
(22) Date of filing: 20.07.2004
(51) Int. Cl.: H01L 21/20

(54) **Method for fabricating a compound semiconductor epitaxial wafer**

(71) Applicant: Atomic Energy Council - Institute of Nuclear Energy Research, Lungtan, Taoyuan, Taiwan (TW)
(72) Inventor: Lan, Shan-Ming Lan Atomic Energy Council, Chiaan Village, Lungtan Taoyuan, Taiwan (TW); Shin, Hwa-Yuh Atomic Energy Council, Chiaan Village, Lungtan Taoyuan, Taiwan (TW)
(74) Representative: Beck, Michael Rudolf

(57) **Abstract**

The present invention discloses a compound semiconductor epitaxial wafer and its fabrication method. The method comprises the following steps: depositing a first buffer layer of silicon (52) on a silicon substrate (51); depositing a compound semiconductor second buffer layer (53) on the first buffer layer; growing a compound semiconductor first epitaxy layer (54) on the second buffer layer; reducing the threading dislocation density by a thermal treatment, which is caused by the discrepancy in the lattice constants or in the thermanl expansion coefficients of the silicon substrate and the compound semiconductor epitaxy layers; growing a compound semiconductor second epitaxy layer (55) on the first epitaxy layer; and, applying a thermal treatment again. Accordingly, a compound semiconductor epitaxy layer with excellent crystal quality is obtained.

## Description

### Field of the invention

The present invention relates to a method for fabricating a compound semiconductor epitaxial wafer. More particularly, it relates to a fabrication method for a good quality crystal formed on a compound semiconductor epitaxy layer by the followings of a silicon buffer layer, a compound semiconductor buffer layer, a compound semiconductor epitaxy layer and heat treatments.

### Description of the related art

The technology of photoelectricity industry and the communication industry has progressed a lot during the past years, so the role of the III-V compounds is becoming increasingly important. The III-V compounds such as GaAs, etc. have become the main base materials for photoelectrical or communicational components owing to its characteristics in direct band-gap and high carrier mobility, and its ability in obtaining materials with different band-gaps by adjusting the chemical composition of the III-V compounds. The photoelectrical and the communicational components of the III-V compound semiconductor are mainly made of substrates of III-V compounds such as GaAs, GaP, InP, wherein the epitaxy is grown with matching the lattices. Now, the diameter of a III-V compound semiconductor substrate is usually under 4 inches, yet that of a silicon substrate can be 12 inches now together with much lower price than that of a III-V compound semiconductor substrate. Therefore, the industrial circles hope to utilize the advantage of the low cost of the silicon substrate as well as the high carrier mobility of the III-V compound semiconductor. They try to grow a film of III-V compound semiconductor on a monocrystalline silicon substrate to produce a light emitting diode, a photodiode, a solar cell, a laser diode, or a high power transistor to lower the cost. However, some problems exist between the two materials of the monocrystalline silicon and the III-V compound semiconductor, like the lattice mismatch and the different thermal expansion coefficients. For example, the lattice constant of monocrystalline silicon and that of GaAs differ for 4.1% at 25°C. The thermal expansion coefficient of monocrystalline silicon and that of GaAs differ for 62% at 25°C. Thus, when growing an epitaxy of III-V compound semiconductor on a monocrystalline silicon substrate, a threading dislocation will happen in the compound semiconductor epitaxy layer owing to the lattice mismatch and the different thermal expansion coefficients.

FIG.1 is a cross-sectional view of a compound semiconductor epitaxial wafer 10 according to US 4,876,219 A. As shown in FIG.1, the wafer 10 comprises a silicon substrate 11, a GaAs first buffer layer 12, a GaAs first epitaxy layer 13, a GaAs second buffer layer 14 and a GaAs second epitaxy layer 15. The fabrication method of the wafer 10 is a metal-organic chemical vapor deposition (MOCVD) process. Firstly, a deposition is applied to a silicon substrate 11 at 450°C to form a GaAs first buffer layer 12 with a thickness of 5 to 20nm (nanometer). Then, an epitaxy process is applied at 650°C to form a GaAs first epitaxy layer 13 with a thickness of 1µm (micrometer). And then, a deposition is applied at 450°C to form a GaAs second buffer layer 14 with a thickness of 5 to 20nm. And then, an epitaxy process is applied at 650°C to form a GaAs second epitaxy layer 15 with a thickness of 2µm.

US 4,876,219 A uses two GaAs buffer layer 12,14 and two GaAs epitaxy layer 13,15 to improve the quality of the GaAs epitaxy on the silicon substrate 11. But in the improvements and verifications of this process by the later researchers, it is found that a heat treatment of a thermal cycle annealing should be added into the process to effectively further improve the quality of the GaAs epitaxy layer.

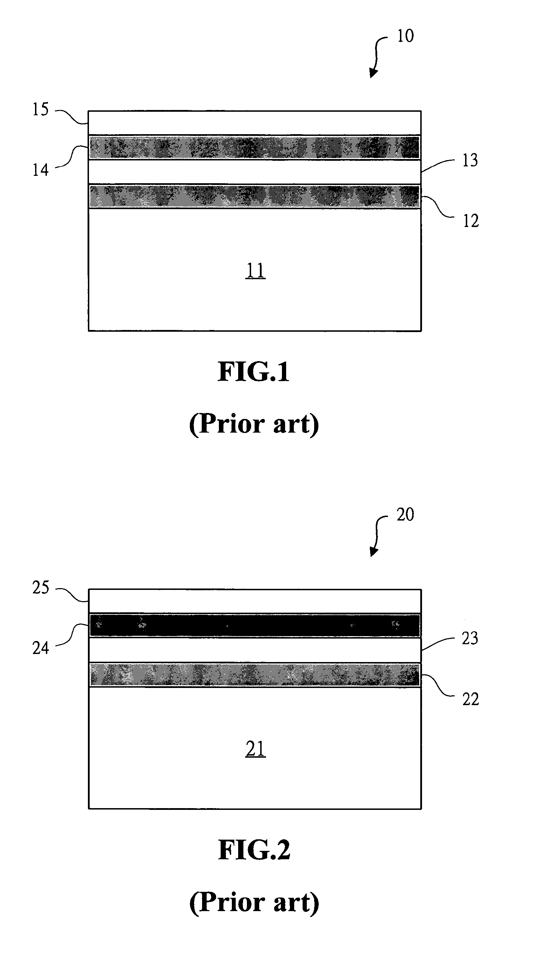

FIG.2 is a cross-sectional view of a compound semiconductor epitaxial wafer 20 according to a prior art based on the paper disclosed in Applied Physics Letters Vol.73, No.20, 1998 pp.2917-2919, "Reduction of threading dislocations by InGaAs interlayer in GaAs layers grown on Si substrate," by Y. Takano et al. (called the paper of Takano et al. hereafter). As shown in FIG.2, the wafer 20 comprises a silicon substrate 21, a GaAs first buffer layer 22, a GaAs first epitaxy layer 23, a InGaAs second buffer layer 24 and a GaAs second epitaxy layer 25. The fabrication method of the wafer 20 is an MOCVD process too. Firstly, a deposition is applied to a silicon substrate 21 at 430°C to form a GaAs first buffer layer 22 with a thickness of 50nm. Then, an epitaxy process is applied at 620°C to form a GaAs first epitaxy layer 23 with a thickness of 2µm. At this time, a process of a thermal cycle annealing follows. Firstly, the epitaxial wafer in the MOCVD system is cooled down to 300°C. When the temperature is reached, the epitaxial wafer is heated up again until 750°C and is sustained at the temperature for 5 minutes. And then, the temperature is lowered down to 300°C again. And then, a deposition is applied at 450°C to form a GaAs second buffer layer 24 with a thickness of 5 to 20nm. And then, an epitaxy process is applied at 650°C to form a GaAs second epitaxy layer 25 with a thickness of 2µm. And then, the temperature is cooled down to 300°C. So forth a thermal cycle is formed. After one or four times of heat treatments of thermal cycle annealing, a deposition is applied at 620°C to form an InGaAs second buffer layer 24 with a thickness of 200nm. And then, an epitaxy process is applied at 620°C to form a GaAs second epitaxy layer 25 with a thickness of 1.8µm.

In the paper of Takano et al., the GaAs first buffer layer 22 and the GaAs first epitaxy layer 23 are processed with a thermal cycle annealing to lower the occurrence of the threading dislocation and to grow a GaAs second buffer layer 24 and a GaAs second epitaxy layer 25 to improve the quality of the GaAs epitaxy on the silicon substrate 21. According to the experiment result from Takano et al., after a cycle of heat treatment of thermal cycle annealing, the double crystal X-ray rocking curve of the GaAs first epitaxy layer 23 is measured as a full width half maximum (FWHM) of 280arcsec (arcsecond). But, after four cycles of heat treatment of thermal cycle annealing, the double crystal X-ray rocking curve of the GaAs first epitaxy layer 23 is measured as down to an FWHM of 140arcsec. This phenomenon shows that the heat treatment of thermal cycle annealing can obviously improve the epitaxy quality of the GaAs on the silicon substrate. But the measurement results of the double crystal X-ray rocking curve of the GaAs second epitaxy layer 25 are not discussed in the paper of Takano et al..

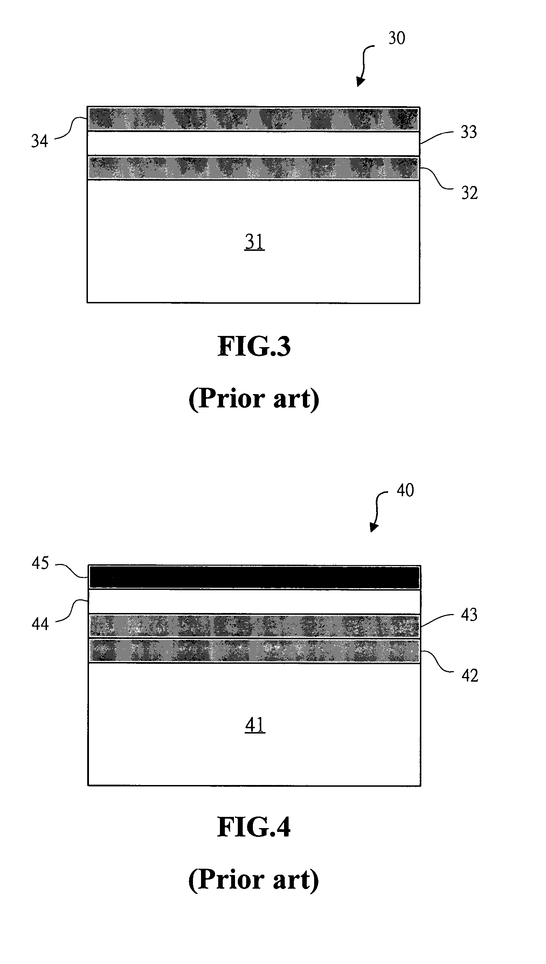

FIG.3 is a cross-sectional view of a compound semiconductor epitaxial wafer 30 according to a prior art based on the paper disclosed in Applied Physics Letters Vol.52, No.19, 1988 pp.1617-1618, "GaAs heteroepitaxial growth on Si for solar cell," by Itoh et al. (called the paper of Itoh et al. hereafter), wherein some methods in the paper of Itoh et al. for growing epitaxy are referred to "Growth of single domain layer on (100) oriented Si substrate by MOCVD," Japanese Journal of Applied Physics Vol.23, No.11, 1984 pp.L843-L845 by M. Akiyama et al.. As shown in FIG.3, the wafer 30 comprises a silicon substrate 31, a GaAs first buffer layer 32, a GaAs first epitaxy layer 33 and a GaAs second epitaxy layer 34. The fabrication method of the wafer 30 is an MOCVD process too. Firstly, a deposition is applied to a silicon substrate 31 at 400°C to form a GaAs first buffer layer 32 with a thickness less than 200nm. Then, an epitaxy process is applied at 700°C to form a GaAs first epitaxy layer 33 with a thickness of 1µm. At this time, a process of a thermal cycle annealing follows. Firstly, the epitaxial wafer in the MOCVD system is cooled down to the room temperature. When the temperature is reached, the epitaxial wafer is heated up again until 850°C and the temperature is sustained for 5 minutes. And then, the temperature is lowered down to 700°C to grow a GaAs second epitaxy layer 34. So forth a thermal cycle is formed. After three to thirteen heat treatments of thermal cycle annealing, the heat treatment is completed and the InGaAs second buffer layer 34 with a thickness of 3 to 4µm is obtained.

In the paper of Itoh et al., the GaAs first buffer layer 32 and the GaAs first epitaxy layer 33 are processed with a thermal cycle annealing together with an epitaxy process to lower the occurrence of the threading dislocation and to obtain a GaAs second buffer layer 34 so that the quality of the GaAs epitaxy on the silicon substrate 31 is improved. According to the experiment result from Itoh et al., after three to thirteen cycles of heat treatment of thermal cycle annealing, the double crystal X-ray rocking curve of the GaAs first epitaxy layer 23 is measured as an FWHM of 130arcsec. So, the method used by Itoh et al. can actually improve the epitaxy quality of the GaAs. But because the heat treatment and the epitaxy process is combined together, the complexity of the process is increased. And according to the result of the double crystal X-ray rocking curve measured, there is still space left for improving the quality of the GaAs second epitaxy layer 34.

FIG.4 is a cross-sectional view of a compound semiconductor epitaxial wafer 40 according to a prior art based on the paper disclosed in Japanese Journal Applied Physics Vol.34, No.7B, 1995 pp.L900~L902, "Photoluminescence spectrum study of the GaAs/Si epilayer grown by using a thin amorphous Si film as buffer layer," by M.S. Hao et al. (called the paper of Hao et al. hereafter). As shown in FIG.4, the wafer 40 comprises a silicon substrate 41, a silicon first buffer layer 42, a GaAs second buffer layer 43, a GaAs first epitaxy layer 44, and a GaAs re-growth second epitaxy layer 45. The fabrication method of the wafer 40 is an MOCVD process too. Firstly, a deposition is applied to a silicon substrate 41 at 600°C to form a silicon first buffer layer 42 with a thickness of 1.5 nm (15Å) having an amorphous structure. Then, a deposition is applied at 400°C to form a GaAs second buffer layer 43 with a thickness of 18nm (180Å). And then, an epitaxy process is applied at 700°C to form a GaAs first epitaxy layer 44 with a thickness of 2.2µm. At this time, the epitaxial wafer is picked out to apply another epitaxy process to re-grow GaAs epitaxy to form a second epitaxy layer 45 on the GaAs first epitaxy layer 44, wherein the temperature for the re-growth of GaAs epitaxy and the thickness of the epitaxy layer are not mentioned in the paper of Hao et al.

In the paper of Hao et al., the occurrence of the threading dislocation is lowered by the followings of a silicon first buffer layer 42, a GaAs second buffer layer 43, a GaAs first epitaxy layer 44 and a second epitaxy layer 45 of GaAs re-growth by a re-epitaxy process; and so the quality of the GaAs epitaxy on the silicon substrate 41 is improved. According to the experiment result from Hao et al., the double crystal X-ray rocking curve of the GaAs first epitaxy layer 44 is measured as an FWHM of 160arcsec; and the second epitaxy layer 45 of GaAs re-growth by a re-epitaxy process is measured as an FWHM of 118arcsec. Therefore, the epitaxy quality disclosed in the paper of Hao et al. is better than that disclosed in the paper of Itoh et al.. But, since a re-growth has to be comprised in the method, the complexity of the method is increased as well. Besides, the epitaxial wafer is apt to be polluted and so the yield of the whole procedure is affected.

### Summary of the invention

The main purpose of the present invention is to provide a compound semiconductor epitaxial wafer together with its fabrication method. To achieve the above purpose, the present invention comprises a silicon substrate, a silicon first buffer layer on the silicon substrate, a compound semiconductor second buffer layer on the silicon first buffer layer, a compound semiconductor first epitaxy layer on the compound semiconductor second buffer layer and a compound semiconductor second epitaxy layer on the compound semiconductor first epitaxy layer.

The method for fabricating the compound semiconductor on the silicon substrate in the present invention is as follows: Firstly, a deposition is applied on a silicon substrate to deposit an amorphous silicon film as a silicon first buffer layer. Then, a deposition for epitaxy growth at a lower temperature is applied on the silicon first buffer layer to deposit a layer of a compound semiconductor film as a compound semiconductor second buffer layer. Then, an epitaxy process for epitaxy growth at a regular temperature is applied on the compound semiconductor second buffer layer to form an epitaxy film of compound semiconductor as a compound semiconductor first epitaxy layer. Then, a heat treatment of thermal cycle annealing is directly applied to the epitaxy growth system to lower the occurrence of the threading dislocation. Then, an epitaxy process for epitaxy growth at a regular temperature is applied on the compound semiconductor second first epitaxy layer to form an epitaxy film of compound semiconductor as a compound semiconductor second epitaxy layer. And then, a heat treatment process of thermal cycle annealing is applied again to eliminate the stress between the silicon substrate and the compound semiconductor second epitaxy layer.

### On comparing with the prior art, the present invention has the following advantages:

The whole epitaxy and the heat treatment are completed in the same epitaxy growth system without applying an epitaxy process again out of the original system so that the complexity of the process and the chance of being polluted are reduced.

The present invention uses a silicon first buffer layer together with a compound semiconductor second buffer layer as the buffer materials between a silicon substrate and compound semiconductor epitaxy layers. By doing so, when processing the heat treatment, the occurrences of the threading dislocations can be reduced by the mutual behaviors of the silicon first buffer layer and the compound semiconductor second buffer layer so that compound semiconductor epitaxy layers with better quality can be obtained.

Two times of thermal cycle annealing are applied in the present invention to have an effective use of the silicon first buffer layer and the compound semiconductor second buffer layer so that the quality of the compound semiconductor epitaxy layers can be improved.

The double crystal X-ray rocking curve of the compound semiconductor epitaxy layer made according to the present invention is measured and the result shows a reduction to an FWHM of 105arcsec (arcsecond). As comparing to the experiment result from Takano et al. as 140arcsec, that from Itoh et al. as 130arcsec and that from Hao et al. as 118arcsec, the compound semiconductor epitaxy layers made by the present invention comprises epitaxy with better quality.

### Brief description of the drawings

The present invention will be better understood from the following detailed description of preferred embodiments of the invention, taken in conjunction with the accompanying drawings, in which:
- FIG.1: is a cross-sectional view of a compound semiconductor epitaxial wafer according to a prior art based on US Patent 4,876,219;
- FIG.2: is a cross-sectional view of a compound semiconductor epitaxial wafer according to a prior art based on the paper of Takano et al.;
- FIG.3: is a cross-sectional view of a compound semiconductor epitaxial wafer according to a prior art based on the paper of Itoh et al.;
- FIG.4: is a cross-sectional view of a compound semiconductor epitaxial wafer according to a prior art based on the paper of Hao et al.;
- FIG.5 to FIG.7: are views showing the fabrication method for a compound semiconductor epitaxial wafer according to the present invention;
- FIG.8: is a view showing the measurement results of the double crystal X-ray rocking curve of a compound semiconductor epitaxial wafer according to the present invention; and
- FIG.9: is a cross-sectional view of a solar cell epitaxial wafer of the first embodiment according to the present invention.

### Detailed description of the preferred embodiments

The following descriptions of the preferred embodiments are provided to understand the features and the structures of the present invention.

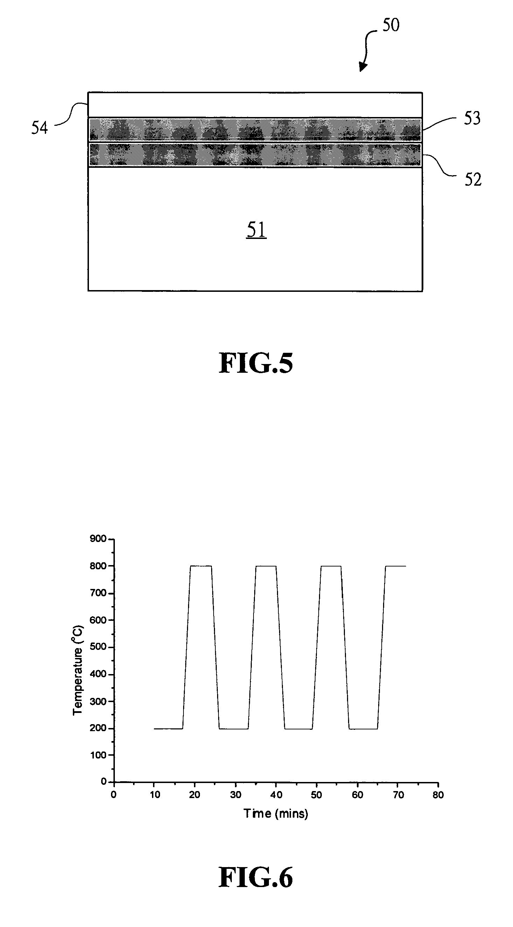

FIG.5, FIG.6 and FIG.7 are views showing the fabrication method for a compound semiconductor epitaxial wafer according to the present invention. As shown in FIG.5, a metal-organic chemical vapor deposition (MOCVD) process is applied in the present invention. Firstly, a deposition is applied on a silicon substrate 51 at 580°C (Celsius degree) by using a process gas of SiH4 to form a layer of an amorphous silicon film with a thickness of 10-25Å (angstrom) to be a silicon first buffer layer 52. Then, a deposition is applied on the silicon first buffer 52 layer at 300°C by using a process gas of Ga(CH3)3 and AsH3 to form a layer of GaAs with a thickness of 100Å to be a compound semiconductor second buffer layer 53. Then, an epitaxy process is applied on the compound semiconductor second buffer layer 53 at 710°C by using a process gas of Ga(CH3)3 and AsH3 to form a layer of GaAs with a thickness of 1.8µm (micrometer) to be a compound semiconductor first epitaxy layer 54. And then, a thermal cycle annealing is applied in the epitaxy growth system for the first time. As shown in FIG.6, the system temperature is cooled down to 200°C at first and is kept at that temperature for 7 minutes; and then the temperature is heated up to 800°C and is kept at that temperature for 5 minutes. Through 4 to 8 times of thermal cycle annealing with high and low temperatures, the occurrence of threading dislocations in the compound semiconductor second buffer layer 54 is reduced.

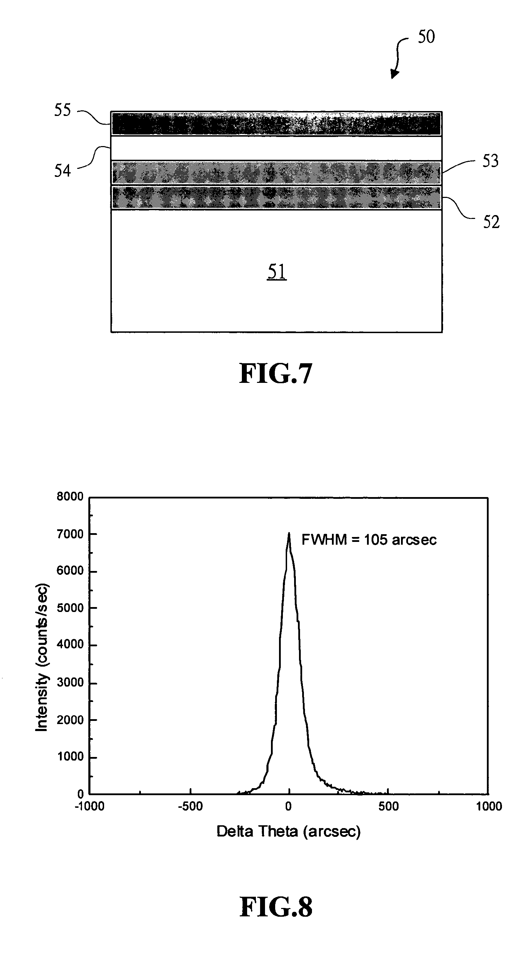

After finishing the first thermal cycle annealing, the temperature is cooled down to 710°C for an epitaxy process. As shown in FIG.7, the epitaxy process is applied on the compound semiconductor first epitaxy layer 54 by using a process gas of Ga(CH3)3 and AsH3 to form a layer of GaAs with a thickness of 1.8µm to be a compound semiconductor second epitaxy layer 55. Then, a thermal cycle annealing is applied in the epitaxy system for the second time. As shown in FIG.6, the system temperature is cooled down to 200°C at first and is kept at that temperature for 7 minutes; and then the temperature is heated up to 800°C and is kept at that temperature for 5 minutes. Through 4 to 8 times of thermal cycle annealing with high and low temperatures, the occurrence of threading dislocations in the compound semiconductor second epitaxy layer 55 is reduced.

As shown in FIG.7 a silicon first buffer layer 52 is grown on a silicon substrate 51. Then, a compound semiconductor second buffer layer 53 is grown on the silicon first buffer layer 52.

Then, a compound semiconductor first epitaxy layer 54 is grown on the compound semiconductor second buffer layer 53. Then, a heat treatment is applied. Then, a compound semiconductor second epitaxy layer 55 is grown on the compound semiconductor first epitaxy layer 54. Then, a heat treatment is applied again. As a result, a compound semiconductor epitaxial wafer 50 with good epitaxy quality can be obtained, wherein the epitaxy growth process is an MOCVD process. The compound semiconductor second buffer layer 53, the compound semiconductor first epitaxy layer 54 and the compound semiconductor second epitaxy layer 55 can also be made of III-V compounds of AlAs, GaP, InAs, or InP in a structure of two-fold, three-fold or four-fold materials.

The compound semiconductor epitaxial wafer 50 made according to the present invention comprises a silicon substrate 51, a silicon first buffer layer 52 on the silicon substrate 51, a compound semiconductor second buffer layer 53 on the silicon first buffer layer 52, a compound semiconductor first epitaxy layer 54 on the compound semiconductor second buffer layer 53 and a compound semiconductor second epitaxy layer 55 on the compound semiconductor first epitaxy layer 54. The silicon first buffer layer 52 and the compound semiconductor second buffer layer 53 are used to match the threading dislocations in the buffer layer to reduce the density of the threading dislocations. And the compound semiconductor first epitaxy layer 54 is to provide a monocrystalline structure for the compound semiconductor second epitaxy layer 55 to grow upon.

FIG.8 is a view showing the measurement of the double crystal X-ray rocking curve of a compound semiconductor epitaxial wafer 50 according to the present invention. As shown in the figure, the FWHM of the GaAs compound semiconductor epitaxy layer is 105arcsec. As comparing to the experiment result from Takano et al. as 140arcsec, that from Itoh et al. as 130arcsec and that from Hao et al. as 118arcsec, it is proved that, by the present invention, the epitaxy quality of the compound semiconductor on the silicon substrate is actually improved.

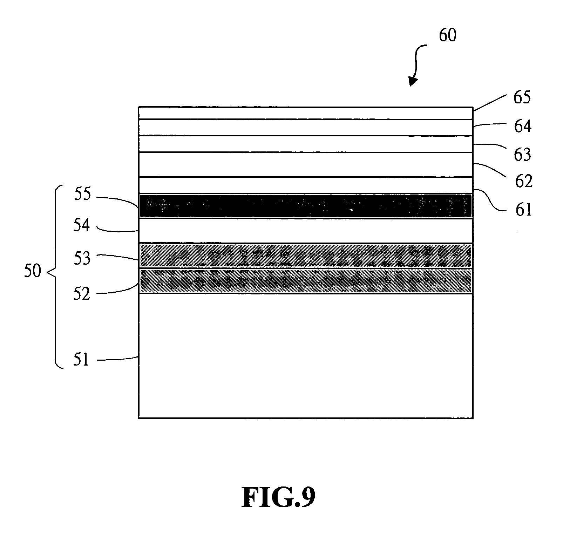

FIG.9 is a cross-sectional view of a solar cell epitaxial wafer 60 of the first embodiment according to the present invention. As shown in FIG.9, the solar cell epitaxial wafer 60 is made by firstly obtain a back side field epitaxy layer 61 on the compound semiconductor epitaxial wafer 50. And then sequentially obtain a base layer 62, an emitter layer 63, a window layer 64 and a contact layer 65 to construct a solar cell.

The preferred embodiments herein disclosed are not intended to unnecessarily limit the scope of the invention. Therefore, simple modifications or variations belonging to the equivalent of the scope of the claims and the instructions disclosed herein for a patent are all within the scope of the present invention.

## Claims

1. Method for fabricating a compound semiconductor epitaxial wafer, comprising:
- providing a silicon substrate (51);
- processing a deposition to form a silicon first buffer layer (52) on said silicon substrate (51);
- processing a deposition to form a compound semiconductor second buffer layer (53) on said silicon first buffer layer (52);
- processing an epitaxy to form a compound semiconductor first epitaxy layer (54) on said compound semiconductor second buffer layer (53);
- processing a heat treatment of thermal cycle to reduce the threading dislocation density;
- processing an epitaxy to form a compound semiconductor second epitaxy layer (55) on said compound semiconductor first epitaxy layer (54); and
- processing a heat treatment of thermal cycle to reduce the threading dislocation density.

2. Method according to claim 1, **characterized in that** the temperature for depositing the silicon first buffer layer (52) is higher than 200°C.

3. Method according to claim 1 or 2, **characterized in that** the temperature for depositing the silicon first buffer layer (52) is lower than 650°C.

4. Method according to one of claims 1 to 3, **characterized in that** the temperature for depositing the compound semiconductor second buffer layer (53) is higher than 200°C.

5. Method according to one of claims 1 to 4, **characterized in that** the temperature for depositing the compound semiconductor second buffer layer (53) is lower than 500°C.

6. Method according to one of claims 1 to 5, **characterized in that** the temperature for obtaining the compound semiconductor first epitaxy layer (54) is higher than 600°C.

7. Method according to one of claims 1 to 6, **characterized in that** the temperature for obtaining the compound semiconductor first epitaxy layer (54) is lower than 1000°C.

8. Method according to one of claims 1 to 7, **characterized in that** the temperature for the heat treatment of thermal cycle is higher than 100°C.

9. Method according to one of claims 1 to 8, **characterized in that** the temperature for the heat treatment of thermal cycle is lower than 1000°C.

10. Method according to one of claims 1 to 9, **characterized in that** said deposition is a metal-organic chemical vapor deposition (MOCVD) process.

11. Method according to one of claims 1 to 10, **characterized in that** said deposition is a molecular beam epitaxy process.

12. Method according to one of claims 1 to 11, **characterized in that** said epitaxy is an MOCVD process.

13. Method according to one of claims 1 to 12, **characterized in that** said epitaxy is a molecular beam epitaxy process.

14. Compound semiconductor epitaxial wafer (50), comprising:
- a silicon substrate (51),
- a silicon first buffer layer (52) on the silicon substrate (51), which (52) is a deposition layer,
- a compound semiconductor second buffer layer (53) on the silicon first buffer layer (52), which (53) is a second deposition layer,
- a compound semiconductor first epitaxy layer (54) on the compound semiconductor second buffer layer (53),
- and a compound semiconductor second epitaxy layer (55) on the compound semiconductor first epitaxy layer (54).

15. Compound semiconductor epitaxial wafer (50) according to claim 15, **characterized by** further layers to form a solar cell.
